# FASCICULE DE BREVET EUROPEEN

(11) **EP 1 793 247 B1**
(45) Date de publication et mention de la délivrance du brevet: **13.04.2011**
(21) Numéro de dépôt: 06291736.4
(22) Date de dépôt: 08.11.2006
(51) Int. Cl.: G02B 6/12, H01L 27/146

(54) **Circuit intégré muni d'au moins une cellule photosensible comprenant un guide de lumière à plusieurs niveaux et procédé de labrication correspondant**
Integrierte Schaltung mit mindestens einer Photozelle und mit einem Vielschicht-Lichtleiter sowie entsprechendes Herstellungsverfahren
Integrated circuit with at least one photocell comprising a multi-level lightguide and corresponding fabrication method

(30) Priorité: 30.11.2005 FR 0512155
(43) Date de publication de la demande: 06.06.2007
(73) Titulaire: STMicroelectronics SA, 92120 Montrouge (FR)
(72) Inventeur: Roy Francois, 38130 Seyssins (FR); Girault Thomas, 38100 Grenoble (FR)
(74) Mandataire: Zapalowicz, Francis

(56) Documents cités:
- EP-A- 1 367 650
- WO-A-99/46618
- US-A1- 2005 001 146
- US-B1- 6 366 365
- US-B2- 6 858 828

## Description

La présente invention concerne une cellule photosensible réalisée dans un circuit intégré et comprenant une face d'entrée et un élément photosensible. L'invention concerne en particulier un circuit intégré comprenant un élément optique.

De nombreux composants optiques intègrent une cellule photosensible. De tels composants sont, par exemple, des détecteurs optiques constitués d'un seul élément, ou cellule, sensible à la lumière incidente sur sa face d'entrée. Il peut aussi s'agir de détecteurs optiques formés d'une matrice de cellules photosensibles juxtaposées les unes à côté des autres, dont les faces d'entrée respectives sont situées dans un plan commun. Les cellules photosensibles sont généralement de dimensions réduites pour obtenir une résolution spatiale suffisante. Elles présentent par exemple une face d'entrée de la lumière de dimensions approximatives égales à 5µm x 5µm. Par conséquent la quantité de lumière entrant dans la cellule photosensible est limitée par la taille de la face d'entrée.

Les cellules détectent la lumière grâce à un élément photosensible qui peut être basé par exemple sur la technologie CMOS et qui permet de convertir le signal lumineux reçu en signal électrique. Les éléments photosensibles nécessitent au moins un et souvent trois niveaux de métallisation pour les connecter aux circuits qui les commandent ou qui traitent leurs informations. Les niveaux de métallisation sont formés de pistes généralement en cuivre, isolées par des couches diélectriques, et sont formés entre l'élément photosensible et la face d'entrée de la lumière de la cellule. Les matériaux diélectriques utilisés pour isoler les pistes doivent donc être transparents aux longueurs d'ondes détectées par l'élément photosensible. Cependant il reste une atténuation de la lumière entre la face d'entrée et l'élément photosensible, surtout lorsque le nombre de niveaux de métallisation regroupés en multicouche augmente.

Pour limiter cette atténuation, il a été proposé dans le document US 2005/0001146 de réaliser un guide optique traversant le multicouche. Pour cela, chaque niveau du multicouche présente un via. Les vias sont alignés et remplis d'un matériau dont l'indice de réfraction est plus élevé que les indices des matériaux formant le multicouche.

Toutefois, la réalisation d'un tel guide est délicate car elle nécessite un alignement rigoureux des vias le constituant, faute de quoi le guide pourrait laisser sortir des photons s'y propageant initialement.

De plus, l'élément photosensible est en général une portion de surface du substrat semi-conducteur spécialement traitée pour remplir cette fonction. Or la surface du substrat comporte également à l'intérieur de la cellule, outre l'élément photosensible, des composants électroniques nécessaires au fonctionnement de l'élément photosensible. L'élément photosensible possède donc une surface photosensible de superficie inférieure à la superficie de la face d'entrée. Par exemple, les dimensions de la surface photosensible sont de 2µm x 2µm pour une face d'entrée de 5µm x 5µm.

Il en résulte donc que, pour une lumière incidente sous forme d'un faisceau uniforme de direction sensiblement perpendiculaire à la face d'entrée, la partie de la lumière qui éclaire le substrat semi-conducteur au niveau des composants électroniques est perdue, puisqu'elle ne parvient pas à l'élément photosensible. Il s'agit sensiblement de la partie de la lumière qui ne rentre pas dans le guide optique. Cette perte provoque une diminution de la sensibilité de la cellule, particulièrement pour les faibles intensités de lumière incidente, par rapport à la sensibilité théorique définie par la taille de la face d'entrée de la lumière dans la cellule.

Une solution à ces inconvénients est proposée dans la demande FR 2 829 876. Un guide de lumière est réalisé par retrait d'une partie du matériau diélectrique d'interconnexion et par dépôt d'un matériau à haut indice de réfraction. Ce guide de lumière présente une forme tronconique dont la grande section est située à proximité de la face d'entrée et dont la petite section est située à proximité de l'élément photosensible. L'élément formant un guide de lumière a pour effet de concentrer la lumière entrant par la grande section vers la surface réduite de l'élément photosensible.

Néanmoins, la réalisation du guide de lumière entraîne la formation d'un trou de profondeur très supérieure à son diamètre, puis son remplissage avec un matériau à indice de réfraction élevé. Cela entraîne, lors du remplissage du guide, des défauts pouvant provoquer des pertes de lumière, ces défauts étant d'autant plus nombreux que la hauteur du guide de lumière est importante.

L'invention vise à remédier aux inconvénients évoqués ci-dessus par un circuit intégré d'après la revendication 1 ou par un procédé de fabrication d'après la revendication 11. La présente invention propose un élément de couplage optique à haut rendement dont l'efficacité dépend peu des défauts d'alignement des différentes parties du circuit intégré.

Un circuit intégré comprend une cellule photosensible pourvue d'une face d'entrée, d'un élément photosensible et d'au moins deux éléments formant un guide de lumière. Les deux éléments sont placés entre la face d'entrée et l'élément photosensible, le deuxième élément étant situé entre le premier élément et la face d'entrée. Les deux éléments guident la lumière provenant de la face d'entrée vers l'élément photosensible. Chaque élément formant un guide de lumière comprend un volume intérieur comprenant au moins un premier matériau diélectrique et un volume extérieur comprenant au moins un second matériau diélectrique dont l'indice de réfraction optique est inférieur à celui du premier matériau. Le volume intérieur présente une première surface située du côté de l'élément photosensible, une deuxième surface située du côté de la face d'entrée et une surface latérale reliant ladite première surface et ladite deuxième surface et séparant les volumes intérieurs et extérieurs, le volume extérieur entourant le volume intérieur sur une partie au moins de la surface latérale. Les deux éléments du guide de lumière sont réalisés de manière que la première surface du volume intérieur du deuxième élément a une superficie plus petite que celle de la deuxième surface du volume intérieur du premier élément.

La réalisation d'un guide de lumière en plusieurs volumes intérieurs présentant chacun un rapport hauteur sur diamètre plus petit, permet un meilleur remplissage par le premier matériau. Le volume intérieur de chaque élément du guide est alors plus homogène, améliorant ainsi le comportement optique du guide. De plus, les parois séparant chaque volume intérieur et extérieur présentent un état de surface plus lisse favorisant aussi les performances du guide. Enfin, le guide présente une sensibilité plus faible aux variations de pente des surfaces latérales des différents éléments grâce à l'épaisseur plus faible desdits éléments.

La différence de superficie entre la première surface du second volume intérieur et la deuxième surface du premier volume intérieur a pour but d'éviter qu'un léger désalignement lors de la réalisation les différents éléments du guide de lumière, n'altère les performances de ce dernier.

L'élément photosensible considéré peut être sensible à la lumière visible, infrarouge et ultraviolette. Les indices de réfraction optiques considérés se rapportent à la longueur d'onde de la lumière pour laquelle la cellule photosensible est conçue.

La face d'entrée est sensiblement parallèle à la surface du support semi-conducteur de l'élément sensible. La présente invention peut aussi être appliquée à d'autres géométries de cellules dans laquelle la face d'entrée n'est pas parallèle à la surface de l'élément sensible.

Le volume intérieur de chaque élément du guide de lumière peut être réalisé de sorte que la superficie de la deuxième surface diminue lorsque le rang de l'élément est plus petit, c'est-à-dire lorsque l'élément est plus proche de l'élément photosensible. Ainsi, le volume intérieur de l'élément du guide le plus proche de la face d'entrée, peut présenter une deuxième surface large de manière à collecter la plus grande partie de la lumière arrivant sur la face d'entrée de la cellule. Les éléments suivants du guide sont ensuite réalisés chacun avec une deuxième surface plus petite que celle de l'élément le plus proche de la face d'entrée. Cela peut être obtenu par exemple en réalisant les volumes intérieurs de chaque élément du guide avec une première surface de superficie petite. Cela permet de réduire la place qu'occupe le guide de lumière dans la cellule, sans diminuer sa sensibilité. Il est alors plus facile de disposer des composants électroniques dans la cellule, à côté du guide de lumière.

Selon un mode préféré de réalisation, la surface latérale d'au moins un volume intérieur est un tronc de cône.

Selon un autre mode préféré de réalisation, la première surface du volume intérieur du deuxième élément est incluse dans celle de la deuxième surface du volume intérieur du premier élément. Les différents éléments du guide de lumière forment alors un seul volume continu. La lumière traverse donc peu d'interfaces lors de sa propagation au sein de la cellule, ce qui permet d'éviter les réflexions et les pertes parasites. La lumière est guidée plus efficacement.

Selon un autre mode de réalisation, au moins un volume intérieur est placé approximativement dans l'épaisseur d'un niveau de métallisation et d'une couche diélectrique associée.

Dans ce mode de réalisation, chaque élément du guide de lumière est réalisé avant les niveaux de métallisation et les couches diélectriques associées, qui sont plus éloignés de l'élément photosensible. Cela permet de faciliter le procédé de fabrication en réalisant chaque élément du guide de lumière après avoir réalisé une partie du multicouche d'interconnexion.

L'invention concerne aussi une matrice photosensible comprenant une pluralité de cellules photosensibles telles que définies précédemment, dans laquelle les faces d'entrées respectives des cellules photosensibles sont dans un même premier plan, et les surfaces des éléments photosensibles respectifs des cellules photosensibles sont dans un même second plan. Certaines de ces cellules peuvent aussi être réalisées en association avec un filtre coloré et/ou avec une microlentille convergente.

L'invention concerne également un procédé de fabrication d'un circuit intégré comprenant un élément photosensible et une première zone diélectrique disposée sur l'élément photosensible. Le procédé comprend :
(a) la formation d'un trou à partir d'une portion de la surface de la première zone diélectrique opposée à l'élément photosensible, sur au moins une partie de l'épaisseur de la première zone diélectrique, le fond du trou présentant une superficie inférieure à celle de l'ouverture,
(b) le remplissage du trou par un matériau d'indice de réfraction supérieur à celui du matériau de la première zone diélectrique pour former un premier élément du guide de lumière présentant une première surface située du côté de l'élément photosensible et une deuxième surface opposée à l'élément photosensible,
(c) le dépôt d'une deuxième zone diélectrique sur le circuit intégré,
(d) la formation d'un deuxième trou à partir d'une portion de la surface de la deuxième zone diélectrique opposée à l'élément photosensible, sur au moins une partie de l'épaisseur de la deuxième zone diélectrique, le fond du trou ayant une superficie plus petite que celle de la deuxième surface du premier élément du guide de lumière,
(e) le remplissage du trou par un matériau d'indice de réfraction supérieur à celui du matériau de la deuxième zone diélectrique pour former un deuxième élément du guide de lumière.

Selon une variante du procédé, la formation du deuxième trou s'effectue sur l'épaisseur de la deuxième zone diélectrique.

En d'autres termes, le guide de lumière comprend une pluralité de troncs de cône. Les troncs de cône sont placés de manière à être traversés successivement par la lumière venant de la face d'entrée et se dirigeant vers l'élément photosensible. La petite section de chaque cône à l'exception de celui le plus proche de l'élément photosensible, est plus petite que la grande section adjacente du tronc de cône voisin placé du côté de l'élément photosensible. Lorsque la distance séparant les deux sections adjacentes est plus grande, la différence de superficie peut être plus importante. La disposition des différents troncs de cône et leur géométrie sont choisies de manière à ce que la plupart des rayons sortant d'un tronc de cône parviennent à l'entrée du tronc de cône suivant. On tient également compte pour cela des écarts de désalignements pouvant apparaître lors de la réalisation du guide.

D'autres particularités et avantages de la présente invention apparaîtront dans la description ci-après d'exemples de réalisation non limitatifs, en référence aux dessins annexés, dans lesquels :
- les figures 1A et 1B sont des vues en coupe d'une cellule photosensible dans un plan contenant l'axe de la cellule ;
- la figure 2 est une vue en coupe d'une matrice formée de cellules semblables à celles illustrée par la figure 1A ;
- les figures 3 à 10 illustrent de manière schématique les différentes étapes de réalisation d'une cellule.

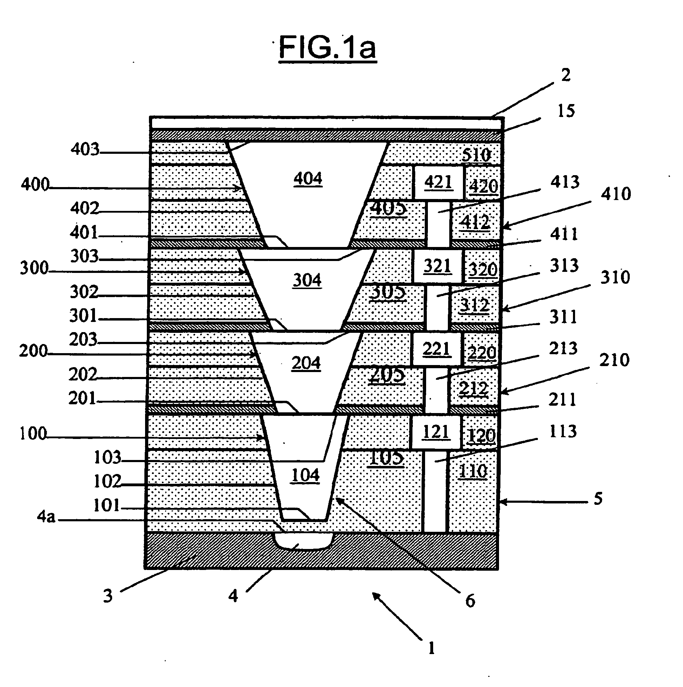

Sur la figure 1A, la cellule photosensible 1 comprend dans sa partie supérieure une plaque transparente formant la face d'entrée de la lumière 2. La plaque peut être une lame de verre ou de matière plastique transparente.

Dans une partie inférieure de la cellule 1, un substrat semi-conducteur 3, disposé sensiblement parallèlement à la face d'entrée, comprend un élément photosensible 4, par exemple une photodiode, centré par rapport à l'axe de la cellule et réalisé au moins en partie dans le support. L'élément photosensible 4 comprend une face d'entrée 4a. Le substrat 3 peut être par exemple un substrat de silicium.

La cellule photosensible 1 comprend également une partie 5 d'interconnexion située entre le substrat semi-conducteur 3 et la face d'entrée de la lumière 2. La partie 5 comprend notamment plusieurs couches 120, 220, 320, 420 de métallisation. Dans l'exemple représenté, la partie d'interconnexion 5 comprend quatre niveaux de métallisation 120, 220, 320, 420. Deux niveaux de métallisation voisins sont séparés par une couche diélectrique 210, 310, 410. La partie d'interconnexion 5 comprend également une couche diélectrique inférieure 110 et une couche diélectrique supérieure 510 de sorte que chaque niveau de métallisation 120, 220, 320, 420 est entouré par une couche diélectrique 110, 210, 310, 410, 510. Chaque couche diélectrique 210, 310, 410 peut comprendre une sous-couche d'arrêt 211, 311, 411 de faible épaisseur comprenant du nitrure de silicium et une sous-couche 212, 312, 412 d'épaisseur importante comprenant de la silice.

Dans l'exemple représenté, un guide de lumière 6 est placé entre la face d'entrée 2 et l'élément photosensible 4. Le guide de lumière 6 comprend une pluralité d'éléments en forme de troncs de cône 100, 200, 300, 400 définissant chacun un volume intérieur 104, 204, 304, 404 et un volume extérieur 105, 205, 305, 405. Les troncs de cône 100, 200, 300, 400 sont superposés et positionnés de façon que leurs axes de symétrie coïncident sensiblement avec celui de la cellule. La section des troncs de cône, pouvant être quelconque, est par exemple carrée.

Chaque tronc de cône 100, 200, 300, 400 comprend une première surface 101, 201, 301, 401 et une deuxième surface 103, 203, 303, 403 sensiblement parallèles à la face d'entrée et à l'élément photosensible, ainsi qu'une surface latérale 102, 202, 302, 402 séparant les volumes intérieurs 104, 204, 304, 404 et les volumes extérieurs 105, 205, 305, 405. La première surface 101, 201, 301, 401 est située du côté de l'élément photosensible et la deuxième surface 103, 203, 303, 403 est située du côté de la face d'entrée. La première surface 101 de l'élément 100 a, par exemple, sensiblement la même superficie que la face active 4a de l'élément photosensible 4. La deuxième surface 403 de l'élément 400 présente une superficie la plus grande possible, par exemple peu inférieure voire égale à la face d'entrée 2.

La première surface 301 du tronc de cône 300 est incluse dans la deuxième surface 203 du tronc de cône 200 situé juste en-dessous dans l'exemple représenté sur la figure 1A. La deuxième surface 203 du cône 200 situé en-dessous a une superficie plus grande que celle de la première surface 301 avec laquelle la surface 203 est en contact. De cette façon, même si les troncs de cône 200 et 300 ne sont pas tout à fait alignés selon leur axe, la première surface 301 reste incluse dans la deuxième surface 203 du tronc de cône 200 placé en-dessous.

De manière à réduire l'encombrement du guide de lumière 6 à proximité de l'élément photosensible 4, la superficie de la deuxième surface 103, 203, 303, 403 peut être d'autant plus petite que le tronc de cône 100, 200, 300, 400 correspondant est proche de l'élément photosensible 4.

Le matériau diélectrique formant les volumes extérieurs 105, 205, 305, 405 comprend au moins un des matériaux choisi dans le groupe formé par : la silice (SiO₂), un verre de silicate dopé au fluor (FSG), ou un composé de silicium, d'oxygène, de carbone et d'azote, représenté sous la forme SiOCₓN_{y}, avec x et y pouvant être nuls, par exemple SiOC. Ces matériaux sont choisis pour leur faible indice de réfraction optique dans les longueurs d'onde de la lumière visible. Le premier matériau diélectrique formant les volumes intérieurs est avantageusement un composé de silicium, d'oxygène, de carbone et d'azote, représenté sous la forme SiOCₓN_{y}, avec x et y pouvant être nuls. Son indice de réfraction optique, selon la stoechiométrie des éléments qui le composent, peut varier entre 1,6 et 2,3. L'oxyde de tantale peut aussi alternativement être utilisé comme premier matériau diélectrique.

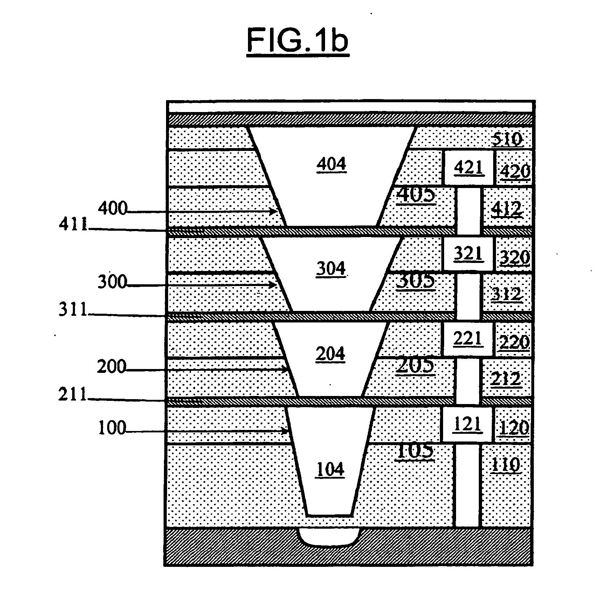

Un second mode de réalisation est représenté sur la figure 1B. Dans ce mode de réalisation, les troncs de cône 100, 200, 300, 400 formant le guide de lumière 6 sont séparés par une couche 211, 311, 411 de faible épaisseur. Cette couche peut comprendre du nitrure de silicium et peut servir de couche d'arrêt lors de la gravure de la couche diélectrique 212, 312, 412.

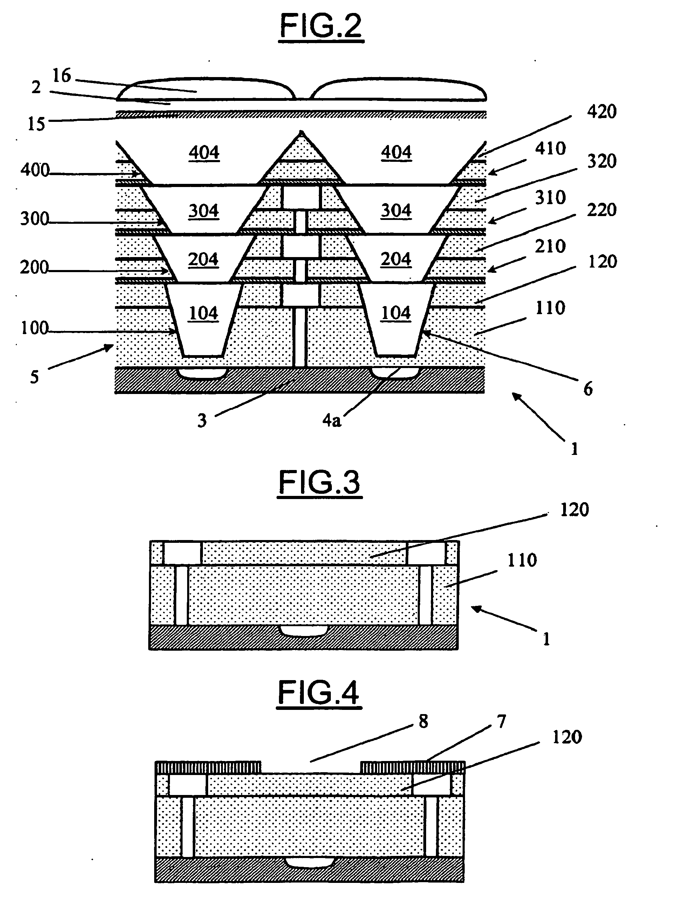

Comme illustré sur la figure 2, un grand nombre de cellules photosensibles similaires à la précédentes peuvent être simultanément réalisées sur la surface d'un support de grande taille. On forme alors une matrice bidimensionnelle de cellules photosensibles, chacune d'elles représentant un point élémentaire, ou « pixel », de l'image obtenue à partir de cette matrice. Les cellules 1 partagent le même support semi-conducteur 3 et la même plaque transparente de face d'entrée 2, comme représenté sur la figure 2. Les faces d'entrée 2 respectives des cellules photosensibles 1 sont ainsi dans un premier plan commun et les faces 4a des éléments photosensibles respectifs des cellules photosensibles 1 sont dans un second plan commun. Chaque cellule 1 contient un guide de lumière 6 composé de plusieurs éléments 100, 200, 300, 400 comme décrit plus haut pour la figure 1A.

La face d'entrée 2 est continue entre deux cellules et transmet la lumière aux cellules photosensibles 1 situées sous cette face d'entrée 2. Les cellules 1 sont distinguées individuellement les unes des autres par leur guide de lumière 6. La forme de chaque pixel est alors déterminée par la surface supérieure du guide de lumière 6 de chaque cellule photosensible 1.

Un filtre coloré 15 associé à chaque cellule 1 peut être disposé en outre au niveau de la face d'entrée 2. La longueur d'onde d'accord du filtre, définissant la couleur pour un filtre opérationnel en lumière incidente visible, peut varier entre deux cellules adjacentes afin de distinguer localement différentes composantes chromatiques de la lumière incidente.

Une microlentille 16 peut être disposée en outre au niveau de la face d'entrée 2. Une telle microlentille 16 permet de concentrer la lumière incidente sur le guide de lumière et contribue ainsi à concentrer la lumière incidente pénétrant par la face d'entrée 2 sur l'élément photosensible 4. La fabrication et la disposition des microlentilles 16 au niveau de la face d'entrée 1 sont effectuées de façon connue en soi.

Les volumes intérieurs 104, 204, 304, 404 sont formés par étapes, en alternant avec la réalisation des différents niveaux de métallisation 120, 220, 320, 420 et de leur couche diélectrique associée 110, 210, 310, 410, 510, comme illustré sur les figures 3 à 10. Sur la figure 3 est représentée une cellule 1 en cours de fabrication, une fois le premier niveau de métallisation 120 formé sur la couche diélectrique 110. Une couche de résine 7 est alors déposée sur toute la surface de la couche 120 puis est insolée à l'emplacement 8 de la deuxième surface du tronc de cône à réaliser. On obtient alors la cellule représentée à la figure 4.

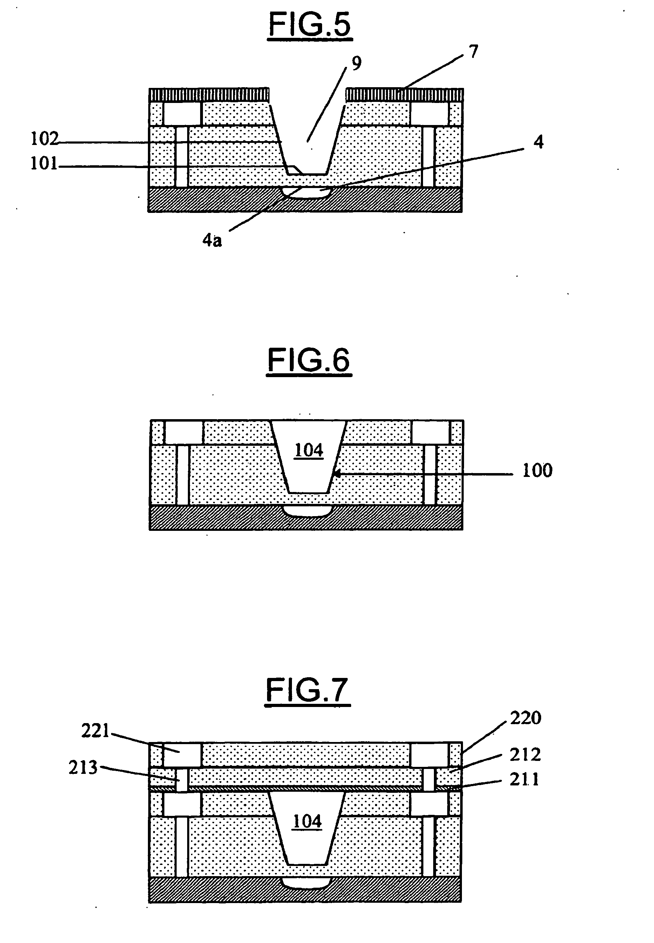

Le circuit intégré est ensuite soumis à un procédé de retrait à l'endroit 8 de l'insolation de la résine. Un procédé de retrait est la gravure assistée par un plasma, notamment par « plasma polymérisant » afin d'obtenir une tranchée 9 dont la surface latérale 102 diminue avec la profondeur. De plus, la diminution de la surface latérale 102 est choisie de manière que le fond de la tranchée 101 ait une superficie sensiblement égale ou inférieure à celle de la face 4a de l'élément photosensible 4. La distance entre le fond de la tranchée 101 et l'élément photosensible 4 peut être choisie inférieure ou de l'ordre de la taille caractéristique de la face 4a. Le circuit obtenu est représenté sur la figure 5.

La résine 7 est alors retirée de la partie non-gravée de la surface supérieure de la cellule par un(des) procédé(s) usuel(s) et le premier matériau diélectrique est déposé, notamment par un dépôt chimique en phase vapeur assisté par plasma (PECVD). Les composés chimiques gazeux utilisés dans ce procédé peuvent être choisis pour apporter simultanément les éléments oxygène, carbone, azote, silicium et éventuellement fluor. Les composés chimiques gazeux sont introduits avec des proportions relatives aboutissant à la composition du matériau déposé qui correspond à la valeur voulue de l'indice de réfraction optique pour le premier matériau diélectrique. L'excès du premier matériau est retiré, par exemple par abrasion. On obtient le circuit représenté sur la figure 6.

On dépose ensuite une deuxième couche diélectrique comprenant une sous-couche 211 comprenant du nitrure de silicium et une sous-couche 212 comprenant de la silice, puis une deuxième couche métal 220. Des vias 213 et des pistes conductrices 221 sont alors réalisés par gravure puis remplis par dépôt. Le circuit intégré obtenu est représenté à la figure 7.

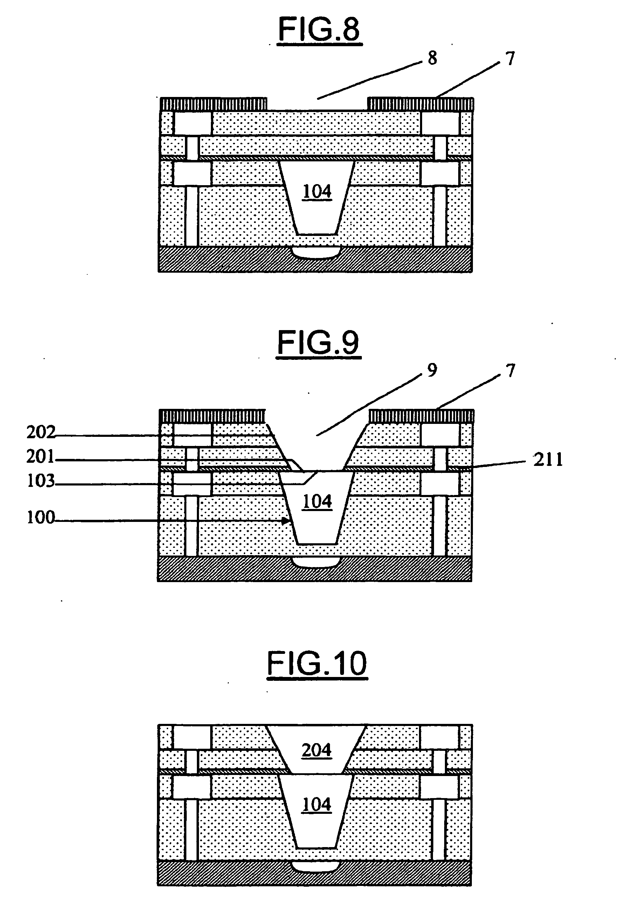

On dépose alors une couche de résine 7 qui est ensuite insolée à l'emplacement 8 de la deuxième surface du tronc de cône à réaliser. On obtient alors la cellule représentée à la figure 8.

Le circuit intégré est ensuite soumis à un procédé de retrait à l'endroit 8 de l'insolation de la résine 7, par une méthode analogue à celle exposée précédemment, jusqu'à parvenir à la sous-couche d'arrêt 211. La pente de la surface latérale 202 est choisie de manière que le fond 201 de la tranchée 9 ait une surface plus petite que celle de la deuxième surface 103 de l'élément 100 du guide de lumière réalisé auparavant. La sous-couche d'arrêt 211 peut être gravée ou non selon qu'on souhaite réaliser le circuit intégré représenté sur la figure 1A ou celui représenté sur la figure 1B. Si on grave la sous-couche d'arrêt 211, le circuit obtenu est celui représenté sur la figure 9.

La résine est retirée de la partie non-gravée de la surface supérieure de la cellule par un(des) procédé(s) usuel(s). Une couche de premier matériau diélectrique est alors déposé comme précédemment et l'excès du premier matériau déposé est retiré, par exemple par abrasion. On obtient le circuit représenté sur la figure 10.

Ces étapes sont à nouveau répétées autant de fois qu'il y a de troncs de cône dans le guide de lumière. La cellule est enfin complétée de manière classique pour obtenir celle illustrée sur la figure 1A.

Pour plus de détails, on pourra se référer à l'ouvrage de Peter Van Zant : « Microchip Fabrication », McGraw-Hill, quatrième édition.

## Revendications

1. Circuit intégré comprenant une cellule photosensible (1) comportant :
- une face d'entrée (2),
- un élément photosensible (4) et
- au moins deux éléments (100, 200) guidant la lumière, placés entre la face d'entrée (2) et l'élément photosensible (4), le deuxième élément (200) étant situé entre le premier élément (100) et la face d'entrée (2) et les deux éléments guidant la lumière provenant de la face d'entrée (2) vers l'élément photosensible (4),
**caractérisé en ce que** chaque élément guidant la lumière comprend :
- un volume intérieur (104, 204) comprenant au moins un premier matériau diélectrique, et
- un volume extérieur (105, 205) comprenant au moins un second matériau diélectrique ayant un indice de réfraction optique inférieur à l'indice de réfraction dudit premier matériau,
- ledit volume intérieur (104, 204) présentant une première surface (101, 201) située du côté de l'élément photosensible (4)., une deuxième surface (103, 203) située du côté de la face d'entrée (2) et une surface latérale (102, 202) reliant ladite première surface (101, 201) et ladite deuxième surface (103, 203) et séparant les volumes intérieur (104, 204) et extérieur (105, 205), le volume extérieur (105, 205) entourant le volume intérieur (104, 204) sur une partie au moins de la surface latérale (102, 202),
la première surface (201) du volume intérieur (204) du deuxième élément (200) ayant une superficie plus petite que celle de la deuxième surface (103) du volume intérieur (104) du premier élément (100).

2. Circuit intégré selon la revendication 1 dans lequel la surface latérale (102, 202) d'au moins un volume intérieur (104, 204) est un tronc de cône.

3. Circuit intégré selon la revendication 1 ou 2, dans lequel la première surface (201) du volume intérieur du deuxième élément est incluse dans celle de la deuxième surface (103) du volume intérieur du premier élément.

4. Circuit intégré selon la revendication 1 ou 2, dans lequel la première surface (201) du volume intérieur du deuxième élément est séparée de la deuxième surface (103) du volume intérieur du premier élément par une couche diélectrique (211).

5. Circuit intégré selon l'une quelconque des revendications précédentes, dans lequel au moins un volume intérieur (204) est placé approximativement dans l'épaisseur d'un niveau de métallisation (220) et d'une couche diélectrique associée (210).

6. Circuit intégré selon l'une quelconque des revendications précédentes, dans lequel le second matériau diélectrique comprend au moins un des matériaux choisi dans le groupe formé par : la silice, un verre de silicate dopé au fluor (FSG) ou un composé de silicium, d'oxygène, de carbone et d'azote, représenté sous la forme SiOCₓN_{y}, avec x et y pouvant être nuls.

7. Circuit intégré selon l'une quelconque des revendications précédentes dans lequel le premier matériau diélectrique comprend du SiOCₓN_{y}, avec x et y pouvant être nuls.

8. Circuit intégré selon l'une quelconque des revendications précédentes comprenant une pluralité de cellules photosensible disposées en matrice, les faces d'entrées (2) respectives des cellules photosensibles étant dans un même premier plan, et les faces des éléments photosensibles (4a) respectifs des cellules photosensibles , étant dans un même second plan.

9. Circuit intégré selon la revendication 8, dans lequel au moins une cellule photosensible comporte un filtre (15) coloré du côté opposé à l'élément photosensible (4).

10. Circuit intégré selon la revendication 8 ou 9 comprenant au moins une microlentille (16) du côté opposé à l'élément photosensible (4).

11. Procédé de fabrication d'un circuit intégré comprenant un élément photosensible (4) et une première zone diélectrique (105) disposée sur l'élément photosensible, comprenant :
- la formation d'un trou (9) à partir d'une portion (8) de la surface de la première zone diélectrique (105) opposée à l'élément photosensible (4), en direction de l'élément photosensible (4), sur au moins une partie de l'épaisseur de la première zone diélectrique (105), le fond du trou (101) présentant une superficie inférieure à celle de l'ouverture (103),
- le remplissage du trou (9) par un matériau d'indice de réfraction supérieur à celui du matériau de la première zone diélectrique (105) pour former un premier élément (100) guidant la lumière et présentant une première surface (101) située du côté de l'élément photosensible (4) et une deuxième surface (103) opposée à l'élément photosensible (4),
- le dépôt d'une deuxième zone diélectrique (205) sur le circuit intégré,
- la formation d'un deuxième trou (9) à partir d'une portion (8) de la surface de la deuxième zone diélectrique (205) opposée à l'élément photosensible (4), sur au moins une partie de l'épaisseur de la deuxième zone diélectrique (205), le fond du trou (201) ayant une superficie plus petite que celle de la deuxième surface (103) du premier élément (100) guidant la lumière,
- le remplissage du trou (9) par un matériau d'indice de réfraction supérieur à celui du matériau de la deuxième zone diélectrique (205) pour former un deuxième élément (200) guidant la lumière, de sorte que les deux éléments guident la lumière provenant de la face d'entrée(2) vers l'élément photosensible (4).

12. Procédé selon la revendication 11 dans lequel la formation du deuxième trou (9) s'effectue sur l'épaisseur de la deuxième zone diélectrique (205).

## Claims

1. Integrated circuit comprising a photosensitive cell (1) including:
- an entry face (2);
- a photosensitive element (4); and
- at least two light-guiding elements (100, 200) that are placed between the entry face (2) and the photosensitive element (4), the second element (200) being located between the first element (100) and the entry face (2), so as to guide the light from the entry face to the photosensitive element **characterized in that** each light-guiding element comprises:
- an inner volume (104, 204) comprising at least a first dielectric material; and
- an outer volume (105, 205) comprising at least a second dielectric material, having an optical refractive index lower than the refractive index of said first material,
said inner volume (104, 204) having a first surface (101, 201) located on the same side as the photosensitive element (4), a second surface (103, 203) located on the same side as the entry face (2), and a lateral surface (102, 202) joining said first surface (101, 201) to said second surface (103, 203) and separating the inner volume (104, 204) from the outer volume (105, 205), the outer volume (105, 205) surrounding the inner volume (104, 204) over at least part of the lateral surface (102, 202), and the first surface (201) of the inner volume (204) of the second element (200) having a smaller area than that of the second surface (103) of the inner volume (104) of the first element (100).

2. Integrated circuit according to Claim 1, in which the lateral surface (102, 202) of at least one inner volume (104, 204) is a cone frustum.

3. Integrated circuit according to either of Claims 1 and 2, in which the first surface (201) of the inner volume of the second element is included within that of the second surface (103) of the inner volume of the first element.

4. Integrated, circuit according to either of Claims 1 and 2, in which the first surface (201) of the inner volume of the second element is separated from the second surface (103) of the inner volume of the first element by a dielectric layer (211).

5. Integrated circuit according to any one of the preceding claims, in which at least one inner volume (204) is placed approximately in the thickness of a metallization level (220) and of an associated dielectric layer (210).

6. Integrated circuit according to any one of the preceding claims, in which the second dielectric material comprises at least one of the materials chosen from the group formed by: silica, a fluorine-doped silicate glass (FSG) or a silicon, oxygen, carbon and nitrogen compound, represented by the formula SiOCₓN_{y}, where x and y may be zero.

7. Integrated circuit according to any one of the preceding claims, in which the first dielectric material comprises SiOCₓ,N_{y}, where x and y may be zero.

8. Integrated circuit according to any one of the preceding claims, comprising a plurality of photosensitive cells arranged in a matrix, the respective entry faces (2) of the photosensitive cells lying in one and the same first plane, and the faces of the respective photosensitive elements (4a) of the photosensitive cells lying in one and the same second plane.

9. Integrated circuit according to Claim 8, in which at least one photosensitive cell includes a colour filter (15) on the opposite side from the photosensitive element (4).

10. Integrated circuit according to Claim 8 or 9, which includes at least one microlens (16) on the opposite side from the photosensitive element (4).

11. Process for fabricating an integrated circuit comprising a photosensitive element (4) and a first dielectric zone (105) placed on the photosensitive element, which process comprises:
- the formation of a hole (9) from a portion (8) of the surface of the first dielectric zone (105) on the opposite side from the photosensitive element (4) in the direction of the photosensitive element (4), over at least part of the thickness of the first dielectric zone (105), the bottom (101) of the hole having a smaller area than that of the aperture (103);
- the filling of the hole (9) with a material of higher refractive index than that of the material of the first dielectric zone (105) in order to form a first light-guiding element (100) having a first area (101) located on the same side as the photosensitive element (4) and a second surface (103) on the opposite side from the photosensitive element (4);
- the deposition of a second dielectric zone (205) on the integrated circuit;
- the formation of a second hole (9) from a portion (8) of the surface of the second dielectric zone (205) on the opposite side from the photosensitive element (4), over at least part of the thickness of the second dielectric zone (205), the bottom (201) of the hole having a smaller area than that of the second surface (103) of the first light-guiding element (100); and
- the filling of the hole (9) with a material of higher refractive index than that of the material of the second dielectric zone (205) in order to form a second light-guiding element (200) so that the two light-guiding elements (100, 200) guide the light from the entry face to the photosensitive element.

12. Process according to Claim 11, in which the second hole (9) is formed in the thickness of the second dielectric zone (205).

## Patentansprüche

1. Integrierter Schaltkreis, der eine photoempfindliche Zelle (1) umfasst, die Folgendes beinhaltet:
- eine Eintrittsseite (2),
- ein photoempfindliches Element (4) und
- mindestens zwei Elemente (100, 200), die das Licht leiten, die zwischen der Eintrittsseite (2) und dem photoempfindlichen Element (4) angebracht sind, wobei das zweite Element (200) zwischen dem ersten Element (100) und der Eintrittsseite (2) liegt, um das Licht von der Eintrittsseite (2) zu dem photoempfindlichen Element (4) zu leiten
**dadurch gekennzeichnet, dass** jedes Element, das das Licht leitet, Folgendes umfasst:
- ein Innenvolumen (104, 204), das mindestens ein erstes dielektrisches Material umfasst, und
- ein Außenvolumen (105, 205), das mindestens ein zweites dielektrisches Material umfasst, das einen optischen Brechungsindex hat, der kleiner ist als der Brechungsindex des ersten Materials,
- wobei das Innenvolumen (104, 204) eine erste Fläche (101, 201), die neben dem photoempfindlichen Element (4) liegt, eine zweite Fläche (103, 203), die neben der Eintrittsseite (2) liegt, und eine seitliche Fläche (102, 202) liegt, die die erste Fläche (101, 201) und die zweite Fläche (103, 203) verbindet und die Innen- (104, 204) und Außenvolumina (105, 205) trennt, aufweist, wobei das Außenvolumen (105, 205) das Innenvolumen (104, 204) auf mindestens einem Teil der seitlichen Fläche (102, 202) umgibt,
wobei die erste Fläche (201) des Innenvolumens (204) des zweiten Elements (200) eine kleinere Oberfläche als die zweite Fläche (103) des Innenvolumens (104) des ersten Elements (100) hat.

2. Integrierter Schaltkreis nach Anspruch 1, wobei die seitliche Fläche (102, 202) mindestens eines Innenvolumens (104, 204) ein Kegelstumpf ist.

3. Integrierter Schaltkreis nach Anspruch 1 oder 2, wobei die erste Fläche (201) des Innenvolumens des zweiten Elements in jener der zweiten Fläche (103) des Innenvolumens des ersten Elements enthalten ist.

4. Integrierter Schaltkreis nach Anspruch 1 oder 2, wobei die erste Fläche (201) des Innenvolumens des zweiten Elements von der zweiten Fläche (103) des Innenvolumens des ersten Elements durch eine dielektrische Schicht (211) getrennt ist.

5. Integrierter Schaltkreis nach einem der vorhergehenden Ansprüche, wobei mindestens ein Innenvolumen (204) ungefähr in der Dicke einer Metallisierungsebene (220) und einer assoziierten dielektrischen Schicht (210) angebracht ist.

6. Integrierter Schaltkreis nach einem der vorhergehenden Ansprüche, wobei das zweite dielektrische Material mindestens ein Material umfasst, das ausgewählt ist aus der Gruppe, gebildet aus: Siliciumdioxid, einem fluordotierten Silicatglas (FSG) oder einer Silicium-, Sauerstoff-, Kohlenstoff- und Stickstoffverbindung, die in Form von SiOCₓN_{y} dargestellt ist, wobei x und y null sein können.

7. Integrierter Schaltkreis nach einem der vorhergehenden Ansprüche, wobei das erste dielektrische Material SiOCₓN_{y} umfasst, wobei x und y null sein können.

8. Integrierter Schaltkreis nach einem der vorhergehenden Ansprüche, der mehrere photoempfindliche Zellen umfasst, die in Matrix angeordnet sind, wobei sich die jeweiligen Eintrittsseiten (2) der photoempfindlichen Zellen in einer gleichen ersten Ebene befinden, und sich die Seiten der jeweiligen photoempfindlichen Elemente (4a) der photoempfindlichen Zellen in einer gleichen zweiten Ebene befinden.

9. Integrierter Schaltkreis nach Anspruch 8, wobei mindestens eine photoempfindliche Zelle einen Farbfilter (15) auf der Seite umfasst, die dem photosensiblen Element (4) gegenüberliegt.

10. Integrierter Schaltkreis nach Anspruch 8 oder 9, der mindestens eine Mikrolinse (16) auf der Seite umfasst, die dem photoempfindlichen Element (4) gegenüberliegt.

11. Verfahren zur Herstellung eines integrierten Schaltkreises, der ein photoempfindliches Element (4) und eine erste dielektrische Zone (105) umfasst, die auf dem photoempfindlichen Element angebracht ist, umfassend:
- die Bildung eines Lochs (9) ausgehend von einem Abschnitt (8) der Fläche der ersten dielektrischen Zone (105), die dem photoempfindlichen Element (4) gegenüberliegt, in Richtung des photoempfindlichen Elements (4), über mindestens einen Teil der Dicke der ersten dielektrischen Zone (105), wobei der Boden des Lochs (101) eine Oberfläche aufweist, die kleiner ist als die der Öffnung (103),
- das Füllen des Lochs (9) mit einem Material mit einem Brechungsindex der größer ist als derjenige des Materials der ersten dielektrischen Zone (105), um ein erstes Element (100) zu bilden, das das Licht leitet, und eine erste Fläche (101) aufweist, die neben dem photoempfindlichen Element (4) liegt, und eine zweite Fläche (103), die dem photoempfindlichen Element (4) gegenüber liegt,
- die Abscheidung einer zweiten dielektrischen Zone (205) auf dem integrierten Schaltkreis,
- die Bildung eines zweiten Lochs (9) ausgehend von einem Abschnitt (8) der Fläche der zweiten dielektrischen Zone (205), die dem photoempfindlichen Element (4) gegenüberliegt, über mindestens einen Teil der Dicke der zweiten dielektrischen Zone (205), wobei der Boden des Lochs (201) eine Oberfläche hat, die kleiner ist als die der zweiten Fläche (103) des ersten Elements (100), das das Licht leitet,
- das Füllen des Lochs (9) mit einem Material mit einem Brechungsindex, der größer ist als der des Materials der zweiten dielektrischen Zone (205), um ein zweites Element (200) zu bilden, das das Licht leitet, so dass die zwei Elemente (100, 200) das Licht von der Eintrittsseite (2) zu dem photoempfindlichen Element (4) leiten.

12. Verfahren nach Anspruch 11, wobei die Bildung des zweiten Lochs (9) auf der Dicke der zweiten dielektrischen Zone (205) durchgeführt wird.
